# EUROPEAN PATENT SPECIFICATION

(11) **EP 0 254 886 B1**
(45) Date of publication and mention of the grant of the patent: **16.06.1993**
(21) Application number: 87109345.6
(22) Date of filing: 29.06.1987
(51) Int. Cl.: G11C 7/00, G11C 8/00

(54) **Serially-accessed type memory device**
Speicheranordnung des Serienzugriffstyps
Dispositif de mémoire du type à accès séquentiel

(30) Priority: 30.06.1986 JP 151582/86
(43) Date of publication of application: 03.02.1988
(73) Proprietor: KABUSHIKI KAISHA TOSHIBA, Kawasaki-shi, Kanagawa-ken 210 (JP)
(72) Inventor: Sahara, Hiroshi Patent Division K.K. Toshiba, Tokyo 105 (JP); Toda, Haruki Patent Division K.K. Toshiba, Tokyo 105 (JP); Oshima, Shigeo Patent Division K.K. Toshiba, Tokyo 105 (JP)
(74) Representative: Lehn, Werner, Dipl.-Ing.

(56) References cited:
- EP-A- 0 152 954
- EP-A- 0 211 565
- US-A- 4 344 156
- ELEKTRONIK, vol.31, no.15, July 1982, pages 27-30, Munich, DE;P.MATTOS et al.: "'Nibble Mode' beschleunigt Speicherzugriff"

## Description

The present invention relates to a serially-accessed type memory device.

In a conventional random access memory, a series of operations are performed in one cycle which is determined in accordance with control signals or address signals of an external input. These operations include accepting and decoding an externally input address in a column direction, activation of a column selection line to transfer data to a data bus line, and activation of an output driver to output the data.

On the other hand, in a memory having a serial access function, an address to be accessed next is determined, unlike in the random access memory. For this reason, the above series of operations need not be performed in one cycle determined by the externally input signals, but can be set up (prepared) beforehand.

However, in the arrangement where only one data transmission system is provided, the above series of operations must be performed by a single data transfer system regardless of an operation state from which an access in a present cycle is started. For this reason, although an access itself can be performed at a high speed, it is difficult to reduce a cycle time.

From "Elektronik", Vol. 31, No. 15, July 1982, pages 27 - 30, Munich, DE; P. Mattos et al.: "Nibble-Mode beschleunigt Speicherzugriff" a serially-accessed type memory device is known which comprises first and second data sources selectively connected to corresponding first and second data lines. A multiplexer selectively connects either of the first and second data lines to an output means.

From EP-A-0 152 954 a semiconductor memory device is known having first and second data sources, first and second data lines, first and second connecting means, output means and switching means.

US-4 344 156 discloses a memory system for rapidly transferring data between a plurality of successive memory locations and a data output bus. In this system, rapid writing of data into the memory is effected by imcluding a number of data buffers which receive income data and are adapted to output that data to a number of successive memory locations. Each buffer is controlled by a sequentially enabled decoder.

EP-A-0 211 565 falling under Article 54(3) EPC describes a random access memory addressed in a sequential mode. In this mode, alternate cells from each of two sets of cells are addressed in such a manner that present data are placed on one data line while preceeding data are read from the other data line.

The present invention has been made in consideration of the above situation, and has as its object to provide a memory device having a column-direction serial access function, which is capable of reducing a cycle time.

In order to solve the object of the present invention, the serially-accessed type memory device comprises a first data source and a second data source;
a first data line and a second data line;
first and second connecting means for selectively connecting said first data source to said first data line and said second data source to said second data line, respectively;
output means for outputting data supplied from either of said first and second data sources through a corresponding one of said first and second data lines; and
first switching means for selectively connecting either of said first and second data lines to said output means;
wherein
said first connecting means include
a first serial address generator for generating first serial address data updated in synchronism with a switching operation of said switching means;
a first decoding means for decoding outputs from said first serial address generator; and
first gating means for connecting said first data source to said first data line in accordance with the output of the first decoding means;
said second connecting means include
a second serial address generator for generating second address data updated in synchronism with a switching operation of said switching means;
a second decoding means for decoding outputs from said second serial address generator; and
second gating means for connecting said second data source to said second data line in accordance with the output of the second decoding means; and
an updating timing of the first address data is offset from an updating timing of the second address data, whereby present data are placed on the first or second data line while preceding data are read from the second or first data line, respectively through the switching means and the output means.

Furthermore, in order to solve the above object of the present invention, the serially-accessed type memory device comprises a first data source and a second data source;
a first data line and a second data line;
first and second connecting means for selectively connecting said first data source to said first data line and said second data source to said second data line, respectively;
input means for supplying write data to either of said first and second data sources through a corresponding one of said first and second data lines; and
first switching means for selectively supplying the write data from said input means to either of said first and second data lines;
wherein
said first connecting means include
a first address generator for generating first address data updated in synchronism with a switching operation of said switching means;
first gating means for connecting said first data source to said first data line in accordance with a content of the first address data;
said second connecting means include
a second address generator for generating second address data updated in synchronism with a switching operation of said switching means;
second gating means for connecting said second data source to said second data line in accordance with a content of the second address data; and
an updating timing of the first address data is offset from an updating timing of the second address data, whereby present data are placed on the first or second data line while preceding data are input through the second or first data line, respectively through the second switching means and the input means.

Advantageous embodiments are given in the dependent claims.

This invention can be more fully understood from the following detailed description when taken in conjunction with the accompanying drawings, in which:
- Fig. 1: is a block diagram of an essential part of a read section used when the present invention is applied to a serially-accessed type semiconductor memory,
- Figs. 2A to 2D: are flow charts for explaining a data read operation of the meoroy shown in Fig. 1;
- Fig. 3: is a block diagram of hardware for alternately operating two data transfer systems (A and B) in the arrangement shown in Fig. 1;
- Figs. 4a to 4C: are views of waveforms for explaining an operation of the hardware shown in Fig. 3;
- Fig. 5: is a block diagram of a modification of the hardware shown in Fig. 3; in which data bus switchers (38 and 39) are replaced with registers (380 and 390);
- Fig.s 6A and 6B: are flow charts for explaining an operation of the memory shown in Fig. 1 using the hardware shown in Fig. 5;
- Fig. 7: is a block diagram of a modification of the hardware shown in Fig. 3; showing hardware capable of reducing a cycle time of the memory shown in Fig. 1 shorter than that obtained by the hardware shown in Fig. 3;
- Fig. 8: is a flow chart for explaining an operation of the memory shown in Fig. 1 using the hardware shown in Fig. 7;
- Fig. 9: is a block diagram partially showing a changed portion used when the arrangement shown in Fig. 1 is applied for data writing; and
- Figs. 10A to 10D: are flow charts for explaining a data write operation used when the arrangement shown in Fig. 9 is applied to the memory shown in Fig. 1.

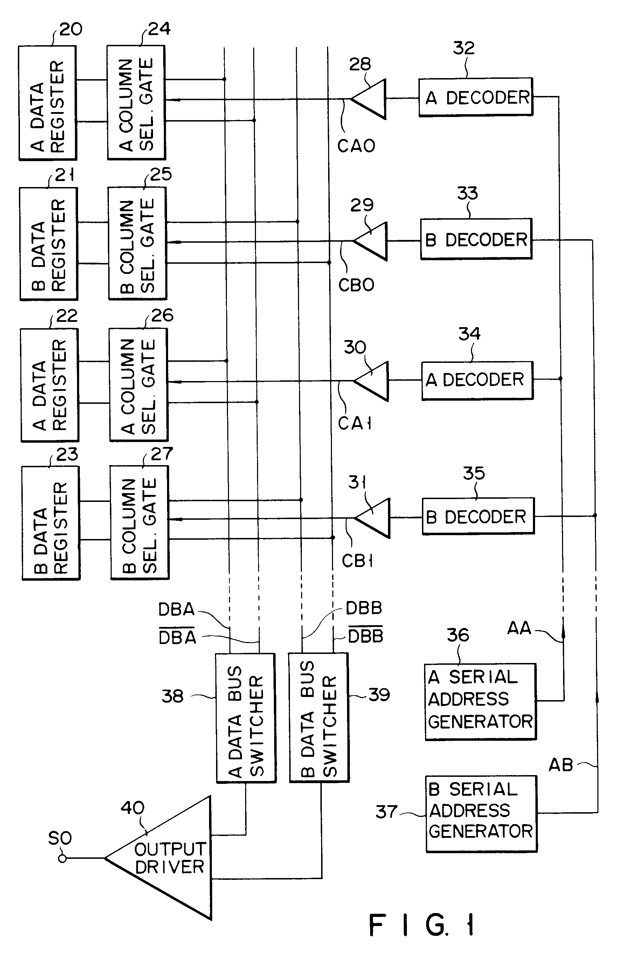

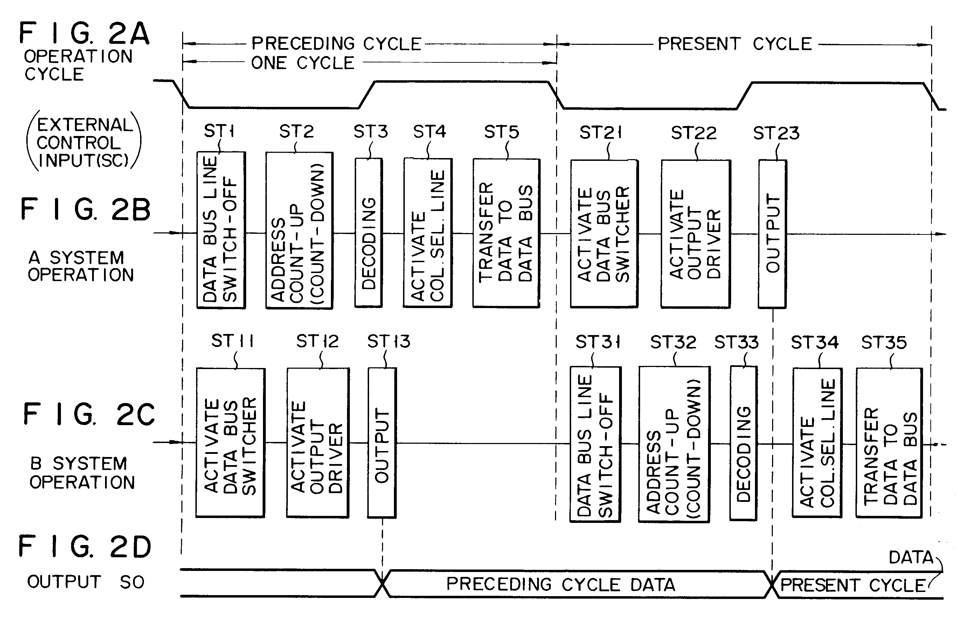

An embodiment of the present invention will now be described with reference to the accompanying drawings. Fig. 1 is a block diagram of an internal circuit arrangement of a column-direction serially-accessed memory according to the embodiment of the present invention, and Figs. 2A to 2D are flow charts for explaining an operation thereof. According to this embodiment, in a semiconductor memory having a column-direction serial access function, two systems A and B for selecting/fetching data are provided in a single chip. Reference numerals 20 and 22 denote A data registers (or A bit lines); 21 and 23, B data registers (or B bit lines); 24 and 26, A column selecting gates; 25 and 27, B column selecting gates; 28 and 30, A column selecting line drivers; 29 and 31, B column selecting line drivers; 32 and 34, A decoders; 33 and 35, B decoders; 36, an A serial address generator; 37, a B serial address generator; 38, an A data bus switcher; 39, a B data bus switcher; 40, an output driver; CA0 and CA1, A column selecting lines; CB0 and CB1, B column selecting lines; DBA and D̅B̅A̅, A data bus lines; DBB and D̅B̅B̅, B data bus lines; AA, an A address bus line; AB, a B address bus line; and SO, a data output. All of these circuit elements can be formed in a one-chip IC pellet.

A data read operation of the memory shown in Fig. 1 will be described. Assume that registers (or bit lines) 20, 21, 22, and 23 are accessed in this order. Note that a description will be made with reference to a case wherein the present cycle is a cycle for accessing data of register 22 which belongs to system A.

In this case, since the preceding cycle is a cycle for accessing from system B, switcher 38 is turned off, as shown in step ST1 of Fig. 2B, and switcher 39 is activated and hence is in an ON state, as shown in step ST11 of Fig. 2C. As shown in steps ST12 and ST13, data of register 21 are transferred to driver 40 through bus lines DBB and D̅B̅B̅.

On the other hand, when system A is disconnected from driver 40 by OFF switcher 38, an address of the present cycle is set in generator 36 (step ST2), and decoder 34 corresponding to the set address is selected (step ST3). Then, selecting line CA1 is activated (step ST4), and data of register 22 are transferred to bus lines DBA and D̅B̅A̅, as shown in step ST5.

When a present cycle, subsequent to the above cycle, begins (Fig. 2A), switcher 39 is turned off as shown in step ST31 of Fig. 2C, and switcher 38 is activated and hence is in an ON state as shown in step ST21 of Fig. 2B. Then, bus lines DBA and D̅B̅A̅ are connected to driver 40 through ON switcher 38 (step ST22). The data of register 22 is transferred to driver 40 as shown in step ST23, and data SO transferred from driver 40 is output.

When system B is disconnected from driver 40, generator 37 is activated, and the address is counted up (or down) as shown in step ST32. Decoder 35 is selected in correspondence to the counted-up (or -down) address (step ST33), and selecting line CB1 is activated (step ST34). Then, the data of register 23 are transferred to bus lines DBB and D̅B̅B̅ as shown in step ST35, thereby completing set-up for access in the next cycle.

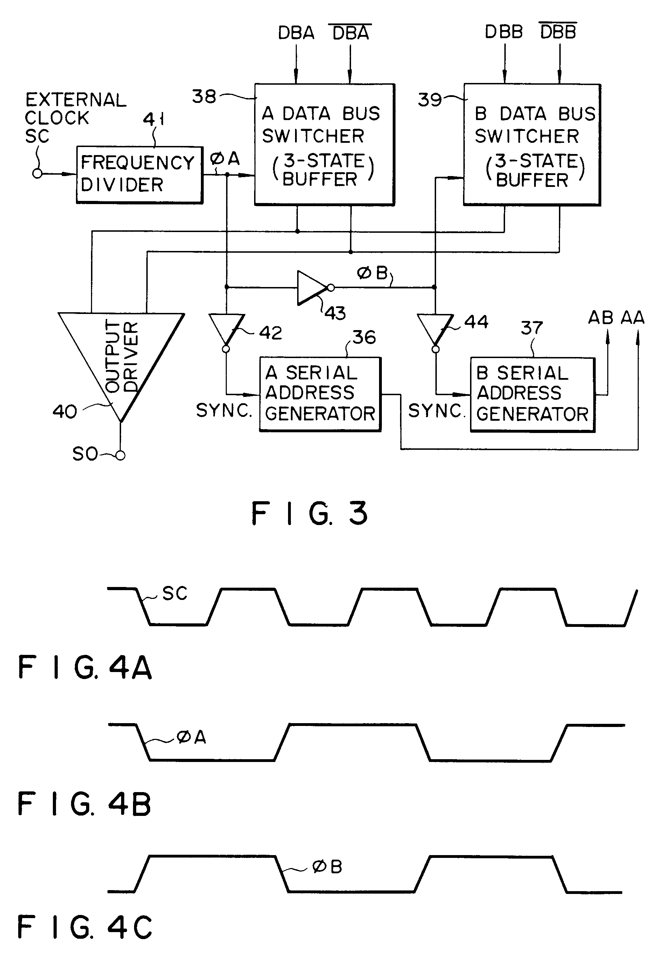

Fig. 3 shows hardware for alternately operating systems A and B in the arrangement shown in Fig. 1. Figs. 4A to 4C shown waveforms for explaining an operation of the hardware shown in Fig. 3.

External clock SC (Fig. 4A) having a period of one cycle shown in Fig. 2A is converted through 1/2 frequency divider 41 into pulse φA (Fig. 4B) for selecting system A. Pulse φA is supplied to a 3-state buffer which constitutes switcher 38. When pulse φA is logic "1", buffer 38 connects bus lines DBA and D̅B̅A̅ to driver 40. When pulse φA is logic "0", buffer 38 is opened, and bus lines DBA and D̅B̅A̅ are disconnected from driver 40.

Pulse φA is phase-inverted, via inverter 42, to be a synchronous signal having the same waveform as that of pulse φB of Fig. 4C, and is supplied to a clock input terminal of an address counter in generator 36. A content (address data) of output AA of generator 36 is updated (counted up or down) by 1 at the fall timing of pulse φA.

In addition, pulse φA is phase-inverted, by inverter 43, to be pulse φB of Fig. 4C. Pulse φB is further phase-inverted, by inverter 44, to be a synchronous signal having the same waveform as that of pulse φA of Fig. 4B, and is supplied to a clock input terminal of an address counter in generator 37. A content (address data) of output AB of generator 37 is updated (counted up or down) by 1 at the fall timing of pulse φB.

On the other hand, In order to select system B, pulse φB is supplied to a 3-state buffer which constitutes switcher 39. When pulse φB is logic "1", buffer 39 connects bus lines DBB and D̅B̅B̅ to driver 40. (At this time, since pulse φA is logic "0", driver 40 is disconnected from bus lines DBA and D̅B̅A̅).

As described above, switchers 38 and 39 are alternately opened/closed every one period (one cycle of Fig. 2A) of clock SC so as to alternately select systems A and B. Then, in synchronism with each alternate selection, the contents of data AA and AB are updated by 1 for every two periods (two cycle of Fig. 2A) of clock SC.

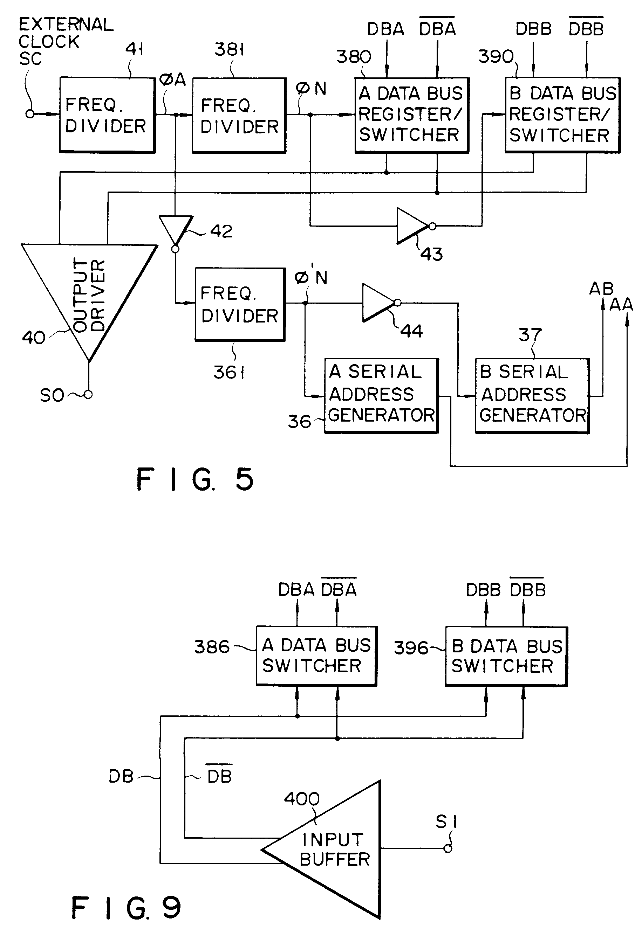

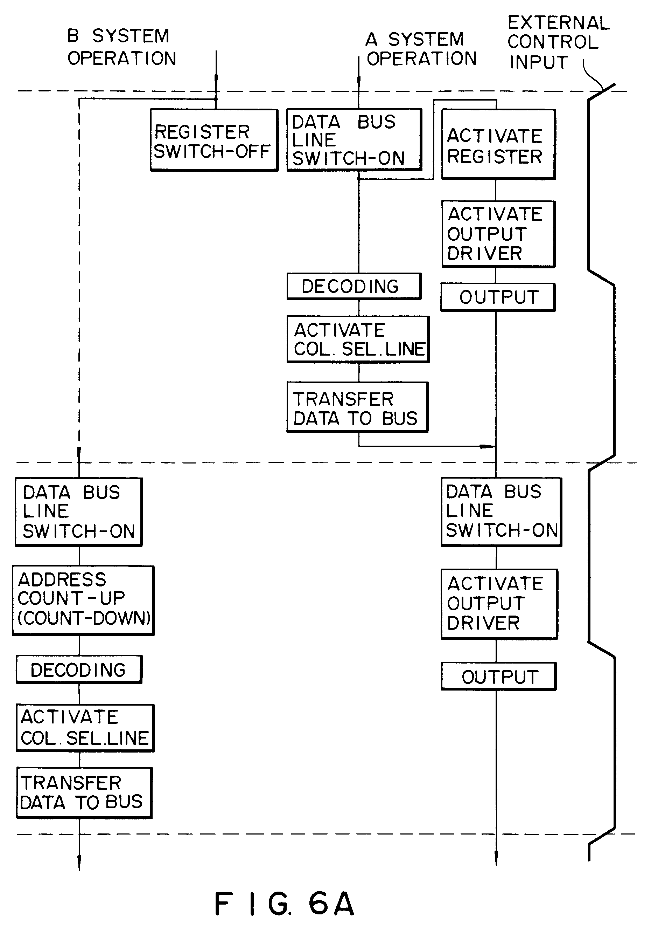

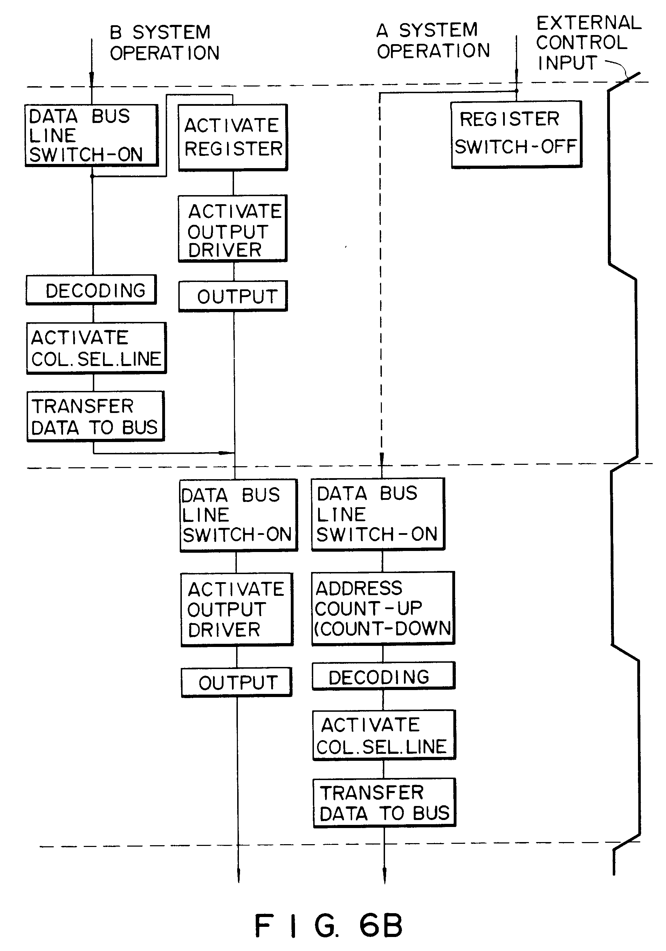

Fig. 5 shows hardware wherein switchers 38 and 39 shown in Fig. 3 are replaced with registers/switchers 380 and 390, respectively. When the hardware shown in Fig. 3 is used, systems A and B are alternately switched in the order of A → B → A → B → .... However, when the hardware shown in Fig. 5 is used, the same data an be alternately switched twice as in the order of A → A → B → B → A → A → B → B → .... This two-time alternate switching operation is exemplified in Figs. 6A and 6B.

When the above two-time alternate switching operation is to be performed, 1/2 frequency divider 381 is inserted between frequency divider 41 and each of registers/switchers 380 and 390, in order that the connections for registers/switchers 380 and 390 are alternatively switched for each two cycles. More specifically, frequency-divided output φN from divider 381 is applied to register/switcher 380, and the phase-inverted signal of output φN, obtained via inverter 43, is applied to register/switcher 390. In this circuit configuration, output signal φN from divider 381 has a period two times longer than the period of clock φA.

In the A system, the data transmission from bus lines DBA, D̅B̅A̅ to register 380 is carried out at the timing of the falling edge of external control clock input SC, provided φN = logic "1". After completion of the data transmission, register 380 is disconnected from bus lines DBA, D̅B̅A̅. Meanwhile, during the period of φN = logic "1", register 380 is connected to output driver 40.

In the B system, the data transmission from bus lines DBB, D̅B̅B̅ to register 390 is carried out at the timing of the falling edge of external control clock input SC, provided φN = logic "0". After completion of the data transmission, register 390 is disconnected from bus lines DBB, D̅B̅B̅. Meanwhile, during the period of φN = logic "0", register 390 is connected to output driver 40.

In the embodiment of Fig. 5, the contents of address AA (or AB) are required to be fixed during the two-time transmission of the same data DBA (or DBB). To satisfy this requirement, 1/2 frequency divider 361 is inserted between frequency divider 41 and each of address generators 36 and 37. More specifically, frequency-divided output φA from divider 41 is applied to frequency divider 361 via inverter 42. Frequency-divided output φN' from divider 361 is applied to address generator 36, and is applied, via inverter 44, to address generator 37. Note here that output φN' from divider 361 is to be activated one cycle in advance of the activation of output φN from divider 381.

According to the embodiment of Fig. 5, when 1/N (N is a natural number) frequency dividers are used both for dividers 361 and 381, an N-time alternate switching operation can be performed.

When the same data is transferred a plurality of times as shown in Fig. 5, reliability of a content of the transferred data can be improved. However, since an operation speed of the memory is reduced, the hardware shown in Fig. 5 may be adopted as necessary.

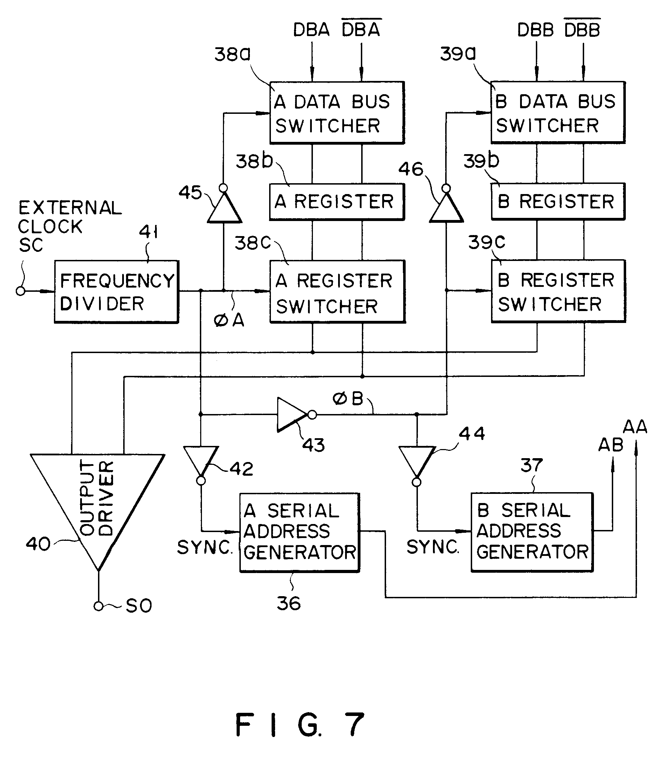

Fig. 7 shows a modification of switchers 38 and 39 shown in Fig. 3. According to the modification shown in Fig. 7, switcher 38a (3-state buffer) is conducted by an output of logic "1" from inverter 45 while switcher 38c (3-state buffer) is opened by logic "0" of pulse φA, thereby storing the data of bus lines DBA and D̅B̅A̅ in register 38b.

While the data of system A is stored, switcher 39c is conducted by logic "1" of pulse φB, and a content of register 39b is supplied to buffer 40. At this time, since an output from inverter 46 is logic "0", switcher 39a is opened.

When φA = logic "1" and φB = logic "0" in the next cycle, a content of register 38b is supplied to driver 40, and at the same time, the data of bus lines DBB and D̅B̅B̅ are stored in register 39b.

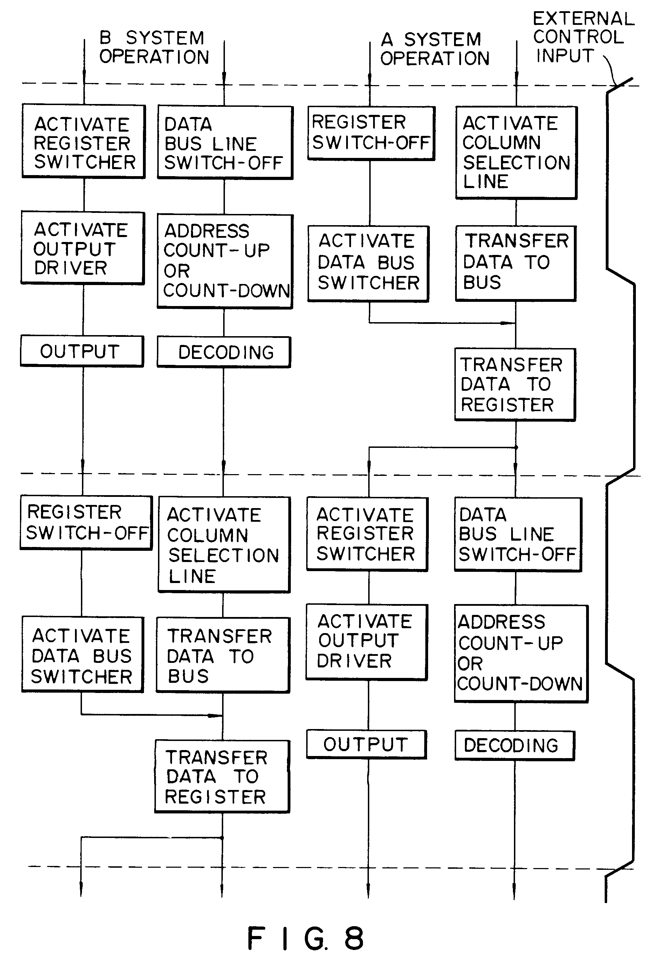

Fig. 8 shows an operation of the modification shown in Fig. 7. As will be seen from a comparison of the flow chart shown in Fig. 8 with those shown in Figs. 2B and 2C, a time required for one cycle is reduced by the arrangement shown in Fig. 7. That is, five steps ST1 to ST5 in one cycle of Fig. 2B are reduced to three serial steps in Fig. 8 when viewed along the serial flow of time. Similarly, five serial steps ST31 to ST35 in Fig. 2C are reduced to three serial steps in Fig. 8. Thus, the number of processing steps, including time-serially in one cycle, is reduced, so that a cycle time can be reduced more effectively.

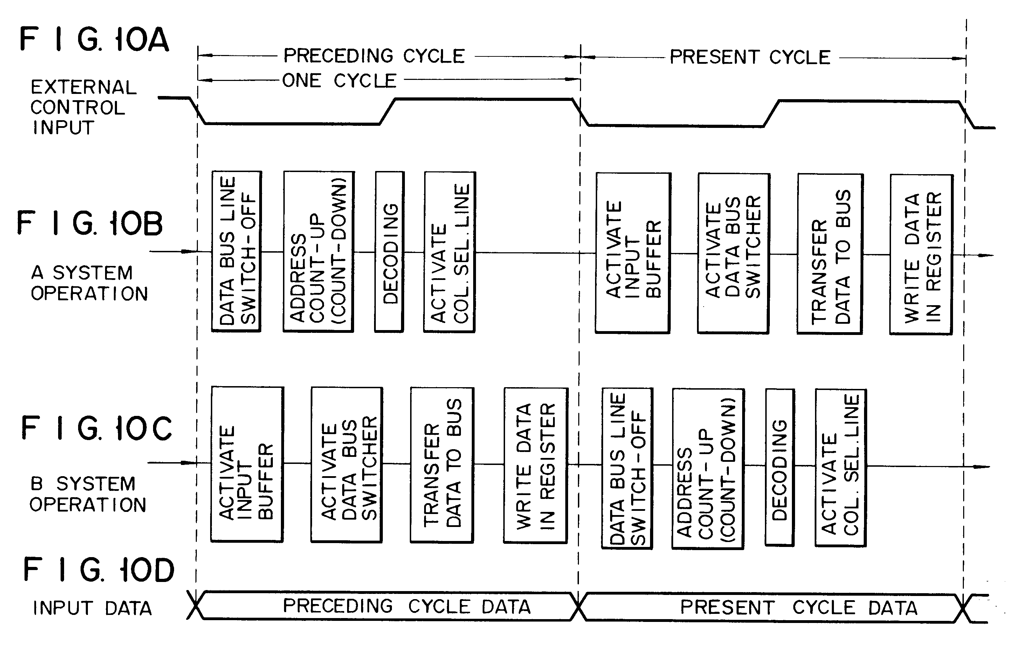

Fig. 9 shows a modified portion when the arrangement (for reading out data) shown in Fig. 1 is modified to that for writing data. Writing input data SI is converted into data DB in phase with data SI and data D̅B̅ opposite phase to data SI through input buffer 400. Data DB and D̅B̅ are supplied to bus lines DBA and D̅B̅A̅ through data bus switcher 386, and are supplied to bus lines DBB and D̅B̅B̅ through switcher 396. The other portions of the arrangement of Fig. 9 can be the same as those of the arrangement shown in Fig. 1. Figs. 10A and 10B show a data write operation of the arrangement, obtained by applying the modified portion shown in Fig. 9 to the arrangement shown in Fig. 1.

According to the embodiments as shown in Fig. 1 etc., systems A and B are operated with a time shift of about 1/2 cycle. For this reason, one cycle time of these embodiments only requires a time substantially half that of a conventional one cycle including steps ST1 to ST5 and ST21 to ST23. Therefore, a cycle time can be reduced. That is, according to the present invention, both the systems (A, B) are alternately operated so that data is set up in one system (e.g., A) while data is output in the other (e.g., B), thereby reducing the cycle time. In addition, when the present invention is applied in a single semiconductor memory chip and two systems (A and B) of data selecting/fetching circuits are provided therein, a high speed memory operation can be achieved by the single chip.

Note that the present invention can be applied to all the memories except a random access type (i.e., wherein an address to be accessed next to the present address is determined). Therefore, the present invention can also be applied to reduction in a read cycle time of a serially-accessed type semiconductor ROM or of a CDROM having two-channel optical pickup systems, etc.

## Claims

1. A serially-accessed type memory device comprising:
- a first data source (20, 22) and a second data source (21, 23);
- a first data line (DBA) and a second data line (DBB);
- first and second connecting means (24, 26, 28, 30, 32, 34, 36 and 25, 27, 29, 31, 33, 35, 37) for selectively connecting said first data source (20, 22) to said first data line (DBA) and said second data source (21, 23) to said second data line (DBB), respectively;
- output means (40) for outputting data (SO) supplied from either of said first and second data sources (20 to 23) through a corresponding one of said first and second data lines (DBA, DBB); and
- first switching means (38, 39) for selectively connecting either of said first and second data lines (DBA, DBB) to said output means (40);
**wherein** :
- said first connecting means (24, 26, 28, 30, 32, 34 and 36) include
-- a first serial address generator (36) for generating first serial address data (AA) updated in synchronism with a switching operation of said switching means (38, 39);
-- a first decoding means (32, 34) for decoding outputs from said first serial address generator (36); and
-- first gating means (24, 26, 28, 30, 32, 34) for connecting said first data source (20, 22) to said first data line (DBA) in accordance with the output of the first decoding means (32, 34);
- said second connecting means (25, 27, 29, 31, 33, 35, 37) include
-- a second serial address generator (37) for generating second address data (AB) updated in synchronism with a switching operation of said switching means (38, 39);
-- a second decoding means (33, 35) for decoding outputs from said second serial address generator (37); and
-- second gating means (25, 27, 29, 31, 33, 35) for connecting said second data source (21, 23) to said second data line (DBB) in accordance with the output of the second decoding means (33, 35); and
- an updating timing of the first address data (AA) is offset from an updating timing of the second address data (AB), whereby present data are placed on the first or second data line while preceding data are read from the second or first data line, respectively, through the switching means and the output means.

2. A memory device according to claim 1, characterized in that:
a switching operation of said switching means (38, 39) is performed such that a first interval (ST1 - ST5, ST21 - ST23), from the timing at which one of said first data sources (20, 22) is accessed by said first connecting means (24, 26, 28, 30, 32, 34, 36) to the timing at which data (DBA = SO) of one of said first data sources (20, 22) is output from said output means (40); partially overlaps a second interval (ST31 - ST35, ST11 - ST13), from the timing at which one of said second data sources (21, 23) is accessed by said second connecting means (25, 27, 29, 31, 33, 35, 37) to the timing at which data (DBB = SO) of one of said second data sources (21, 23) is output from said output means (40).

3. A memory device according to claim 2, characterized in that:
the switching operation of said switching means is performed every N operation cycles of said memory device, wherein N is an integer of 1 or more, and one bit of data is read out during one operation cycle.

4. A memory device according to claim 3, characterized in that:
said switching means (38, 39) includes first buffer means (38) for selectively connecting said first data line (DBA) to said output means (40), and second buffer means (39) for selectively connecting said second data line (DBB) to said output means (40), and said first and second buffer means (38, 39) are alternately opened/closed every N operation cycles to perform the switching operation.

5. A memory device according to any one of claims 1 to 3, characterized in that:
said switching means (38, 39) includes first register means (3809, 38a - 38c) for temporarily storing data from either of said first data sources (20, 22) and selectively supplying the stored data to said output means (40), and second register means (390, 39a - 39c) for temporarily storing data from either of said second data sources (21, 23) and selectively supplying the stored data to said output means (40), and that said first and second register means (380, 390, 38a - 38c, 39a - 39c) are alternately operated to perform a selective supply operation.

6. A memory device according to claim 5, further comprising:
control means (41 - 46) for controlling the switching operation of said first and second register means (380, 390, 38a - 38c, 39a - 39c), such that data from either of said second data sources (21, 23) is temporarily stored in said second register means (390, 39a - 39c) during an interval wherein the data temporarily stored in said first register means (380, 39a - 38c) is supplied to said output means (40), and such that data from either of said first data sources (20, 22) is temporarily stored in said first register means (380, 38a - 38c) during an interval wherein the data temporarily stored in said second register means (390, 39a - 39c) is supplied to said output means (40).

7. A serially-accessed type memory device comprising:
- a first data source (20, 22) and a second data source (21, 23);
- a first data line (DBA) and a second data line (DBB);
- first and second connecting means (24, 26, 28, 30, 32, 34, 36 and 25, 27, 29, 31, 33, 35, 37) for selectively connecting said first data source (20, 22) to said first data line (DBA) and said second data source (21, 23) to said second data line (DBB), respectively;
- input means (400) for supplying write data (S1) to either of said first and second data sources (20 to 23) through a corresponding one of said first and second data lines (DBA, DBB); and
- first switching means (386, 396) for selectively supplying the write data (S1) from said input means (400) to either of said first and second data lines (DBA, DBB);
**wherein** :
- said first connecting means (24, 26, 28, 30, 32, 34 and 36) include
-- a first address generator (36) for generating first address data (AA) updated in synchronism with a switching operation of said switching means (38, 39);
-- first gating means (24, 26, 28, 30, 32, 34) for connecting said first data source (20, 22) to said first data line (DBA) in accordance with a content of the first address data (AA);
- said second connecting means (25, 27, 29, 31, 33, 35, 37) include
-- a second address generator (37) for generating second address data (AB) updated in synchronism with a switching operation of said switching means (38, 39);
-- second gating means (25, 27, 29, 31, 33, 35) for connecting said second data source (21, 23) to said second data line (DBB) in accordance with a content of the second address data (AB); and
- an updating timing of the first address data (AA) is offset from an updating timing of the second address data (AB), whereby present data are placed on the first or second data line while preceding data are input through the second or first data line, respectively through the second switching means and the input means.

8. A memory device according to claim 8, further comprising:
output means (40) for outputting read data (SO) output from either of said first and second data sources (20 - 23) through a corresponding one of said first and second data lines (DBA, DBB); and
read switching means (38, 39) for selectively connecting either of said first and second data lines (DBA, DBB) to said output means (40).

## Patentansprüche

1. Speichervorrichtung mit sequentiellem Zugriff mit:
einer ersten Datenquelle (20, 22) und einer zweiten Datenquelle (21, 23);
einer ersten Datenleitung (DBA) und einer zweiten Datenleitung (DBB);
ersten und einer zweiten Verbindungseinrichtungen (24, 26, 28, 30, 32, 34, 36 und 25, 27, 29, 31, 33, 35, 37) zum selektiven Verbinden der ersten Datenquelle (20, 22) mit der ersten Datenleitung (DBA) und der zweiten Datenquelle (21, 23) mit der zweiten Datenleitung (DBB);
einer Ausgabeeinrichtung (40) zum Ausgeben von Daten (SO) zugeführt von einer der ersten und zweiten Datenquellen (20 bis 23) durch eine entsprechende der ersten und zweiten Datenleitungen (DBA, DBB); und
einer ersten Schalteinrichtung (38, 39) zum selektiven Verbinden von entweder der ersten oder der zweiten Datenleitung (DBA, DBB) mit der Ausgabeeinrichtung (40);
wobei
die erste Verbindungseinrichtung (24, 26, 28, 30, 32, 34 und 36) beinhaltet:
einen ersten Reihenadressengenerator (36) zum Erzeugen von ersten Reihenadressendaten (AA), aufgefrischt synchron mit einem Schaltbetrieb der Schalteinrichtung (38, 39);
eine erste Dekodiereinrichtung (32, 34) zum Dekodieren von Ausgaben vom ersten Reihenadressengenerator (36); und
eine erste Gateeinrichtung (24, 26, 28, 30, 32, 34) zum Verbinden von der ersten Datenquelle (20, 22) mit der ersten Datenleitung (DBA) in Übereinstimmung mit der Ausgabe der ersten Dekodiereinrichtung (32, 34);
wobei die zweite Verbindungseinrichtung (25, 27, 29, 31, 33, 35, 37) beinhaltet:
einen zweiten Reihenadressengenerator (37) zum Erzeugen zweiter Adressendaten (AB), aufgefrischt synchron mit einem Schaltbetrieb der Schalteinrichtungen (38, 39);
eine zweite Dekodiereinrichtung zum Dekodieren von Ausgaben von dem zweiten Reihenadressengenerator (37); und
eine zweite Gateeinrichtung (25, 27, 29, 31, 33, 35) zum Verbinden der zweiten Datenquelle (21, 23) mit der zweiten Datenleitung (DBB) in Übereinstimmung mit der Ausgabe der zweiten Dekodiereinrichtung (33, 35); und
wobei ein Auffrischzeitpunkt der ersten Adreßdaten (AA) versetzt ist von einem Auffrischzeitpunkt der zweiten Adreßdaten (AB), wodurch gegenwärtige Daten auf die erste oder zweite Datenleitung plaziert werden, während vorhergehende Daten ausgelesen werden von der zweiten bzw. ersten Datenleitungdurch die Schalteinrichtung und die Ausgabeeinrichtung.

2. Speichervorrichtung nach Anspruch 1, dadurch gekennzeichnet, daß
ein Schaltbetrieb der Schalteinrichtung (38, 39) so durchgeführt wird, daß ein erstes Intervall (ST1 bis ST5, ST21 bis ST23) vom Zeitpunkt, zu dem auf eine der ersten Datenquellen (20, 22) zugegriffen wird durch die erste Verbindungseinrichtung (24, 26, 28, 30, 32, 34, 36) bis zum Zeitpunkt, zu dem Daten (DBA = SO) einer der ersten Datenquellen (20, 22) ausgegeben werden von der Ausgabeeinrichtung (40), teilweise überlappt mit einem zweiten Intervall (ST31 bis ST35, ST11 bis ST13) von dem Zeitpunkt, zu dem auf eine der zweiten Datenquellen (21, 23) zugegriffen wird durch die zweite Verbindungseinrichtung (25, 27, 29, 31, 33, 35, 37) bis zu dem Zeitpunkt, zu dem Daten (DBB = S0) einer der zweiten Datenquellen ausgegeben werden von der Ausgabeeinrichtung (40).

3. Speichervorrichtung nach Anspruch 2, dadurch gekennzeichnet, daß der Schaltbetrieb der Schalteinrichtung durchgeführt wird alle N-Betriebszyklen der Speichervorrichtung, wobei N eine natürliche Zahl von 1 oder mehr ist, und ein Bit von Daten ausgelesen wird während eines Betriebszyklus.

4. Speichervorrichtung nach Anspruch 3, dadurch gekennzeichnet, daß die Schalteinrichtung (38, 39) eine erste Puffereinrichtung (38) zum selektiven Verbinden der ersten Datenleitung (DBA) mit der Ausgabeeinrichtung (40) und eine zweite Puffereinrichtung (39) zum selektiven Verbinden der zweiten Datenleitung (DBB) mit der Ausgabeeinrichtung umfaßt, und daß die ersten und zweiten Puffereinrichtungen (38, 39) alternierend geöffnet/geschlossen werden alle N-Betriebszyklen, um den Schaltbetrieb durchzuführen.

5. Speichervorrichtung nach einem der Ansprüche 1 bis 3, dadurch gekennzeichnet, daß die Schalteinrichtungen (38, 39) eine erste Registereinrichtung (380, 38a bis 38c) zum zeitweiligen Speichern von Daten von einer der ersten Datenquellen (20, 22) und selektiven Zuführen der gespeicherten Daten an die Ausgabeeinrichtung (40) und eine zweite Registereinrichtung (390, 39a bis 39c) zum zeitweiligen Speichern von Daten von einer der zweiten Datenquellen (21, 23) und selektiven Zuführen der gespeicherten Daten an die Ausgabeeinrichtung (40) umfaßt, und daß die erste und zweite Registereinrichtung (380, 390, 38a bis 38c, 39a bis 39c) alternierend betrieben werden, um eine selektive Zuführoperation durchzuführen.

6. Speichervorrichtung nach Anspruch 5, gekennzeichnet durch
eine Steuereinrichtung (41 bis 46) zum Steuern des Schaltbetriebs der ersten und zweiten Registereinrichtung (380, 390, 38a bis 38c, 39a bis 39c), so daß Daten von einer der zweiten Datenquellen (21, 23) zeitweise gespeichert werden in der zweiten Registereinrichtung (390, 39a bis 39c) während eines Intervalls, wobei die Daten, welche zeitweise gespeichert sind in der ersten Registereinrichtung (380, 38a bis 38c) zugeführt werden an die Ausgabeeinrichtung (40), und so daß Daten von einer der ersten Datenquellen (20, 22) zeitweise gespeichert werden in der ersten Registereinrichtung (380, 38a bis 38c) während eines Intervalls, wobei die Daten, die zeitweise gespeichert sind in der zweiten Registereinrichtung (390, 39a bis 39c) zugeführt werden an die Ausgabeeinrichtung (40).

7. Speichervorrichtung mit sequentiellem Zugriff mit:
einer ersten Datenquelle (22) und einer zweiten Datenquelle (21, 23);
einer ersten Datenleitung (DBA) und einer zweiten Datenleitung (DBB);
ersten und einer zweiten Verbindungseinrichtungen 24, 26, 28, 30, 32, 34, 36 und 25, 27, 29, 31, 33, 35, 37) zum selektiven Verbinden der ersten Datenquelle (22) mit der ersten Datenleitung (DBA) und der zweiten Datenquelle (21, 23) mit der zweiten Datenleitung (DBB);
einer Eingabeeinrichtung (400) zum Zuführen von Schreibdaten (S1) an eine der ersten und zweiten Datenquellen (20 bis 23) durch eine entsprechende der ersten und zweiten Datenleitungen (DBA, DBB); und
einer ersten Schalteinrichtung (386, 396) zum selektiven Zuführen der Schreibdaten (S1) von der Eingabeeinrichtung (400) in eine der ersten und zweiten Datenleitungen (DBA, DBB);
wobei
die erste Verbindungseinrichtung (24, 26, 28, 30, 32, 34 und 36) beinhaltet:
einen ersten Adressengenerator (36) zum Erzeugen von ersten Adressendaten (AA), aufgefrischt synchron mit einem Schaltbetrieb der Schalteinrichtung (38, 39);
eine erste Gateeinrichtung 24, 26, 28, 30, 32, 34) zum Verbinden der ersten Datenquelle (20, 22) mit der ersten Datenleitung (DBA) in Übereinstimmung mit einem Inhalt der ersten Adressendaten (AA);
wobei die zweite Verbindungseinrichtung (25, 27, 29, 31, 33, 35, 37) beinhaltet:
einen zweiten Adressengenerator (37) zum Erzeugen von zweiten Adreßdaten (AB), aufgefrischt synchron mit einem Schaltbetrieb der Schalteinrichtung (38, 39);
eine zweite Gateeinrichtung (25, 27, 29, 31, 33, 35) zum Verbinden der zweiten Datenquelle (21, 23) mit der zweiten Datenleitung (DBB) in Übereinstimmung mit einem Inhalt der der zweiten Adreßdaten (AB), und
wobei ein Auffrischzeitpunkt der ersten Adreßdaten (AA) verschoben ist von einem Auffrischzeitpunkt der zweiten Adreßdaten (AB), wodurch gegenwärtige Daten auf die erste oder zweite Datenleitung plaziert werden, während vorhergehende Daten angegeben werden durch die zweite bzw. erste Datenleitung durch die zweite Schalteinrichtung und die Eingabeeinrichtung.

8. Speichervorrichtung nach Anspruch 7, gekennzeichnet durch
eine Ausgabeeinrichtung (40) zum Ausgeben von Lesedaten (SO), ausgegeben von einer der ersten und zweiten Datenquellen (20 bis 23) durch eine entsprechende der ersten und zweiten Datenleitungen (DBA, DBB); und
eine Leseschalteinrichtung (38, 39) zum selektiven Verbinden von einer der ersten und zweiten Datenleitungen (DBA, DBB) mit der Ausgabeeinrichtung (40).

## Revendications

1. Dispositif de mémoire du type à accès série comprenant :
une première source de données (20, 22) et une seconde source de données (21, 23) ;
une première ligne de données (DBA) et une seconde ligne de données (DBB) ;
des premier et second moyens de connexion (24, 26, 28, 30, 32, 34, 36 et 25, 27, 29, 31, 33, 35, 37) pour connecter respectivement de façon sélective ladite première source de données (20, 22) à ladite première ligne de données (DBA) et ladite seconde source de données (21, 23) à ladite seconde ligne de données (DBB) ;
un moyen de sortie (40) pour émettre en sortie des données (SO) appliquées depuis l'une ou l'autre desdites première et seconde sources de données (20 à 23) au travers d'une ligne correspondante prise parmi lesdites première et seconde lignes de données (DBA, DBB) ; et
un premier moyen de commutation (38, 39) pour connecter de façon sélective l'une ou l'autre desdites première et seconde lignes de données (DBA, DBB) audit moyen de sortie (40) ;
dans lequel :
ledit premier moyen de connexion (24, 26, 28, 30, 32, 34 et 36) inclut :
un premier générateur d'adresses série (36) pour générer les premières données d'adresse série (AA) mises à jour en synchronisation avec une opération de commutation dudit moyen de commutation (38, 39) ;
un premier moyen de décodage (32, 34) pour décoder des sorties en provenance dudit premier générateur d'adresses série (36) ; et
un premier moyen de porte (24, 26, 28, 30, 32, 34) pour connecter ladite première source de données (20, 22) à ladite première ligne de données (DBA) en relation avec la sortie du premier moyen de décodage (32, 34) ;
ledit second moyen de connexion (25, 27, 29, 31, 33, 35, 37) inclut :
un second générateur d'adresses série (37) pour générer des secondes données d'adresse (AB) mises à jour en synchronisation avec une opération de commutation dudit moyen de commutation (38, 39) ;
un second moyen de décodage (33, 35) pour décoder des sorties en provenance dudit second générateur d'adresses série (37) ; et
un second moyen de porte (25, 27, 29, 31, 33, 35) pour connecter ladite seconde source de données (21, 23) à ladite seconde ligne de données (DBB) en relation avec la sortie du second moyen de décodage (33, 35); et
un cadencement de mise à jour des premières données d'adresse (AA) est décalé par rapport à un cadencement de mise à jour des secondes données d'adresse (AB) d'où il résulte que des données courantes sont respectivement placées sur la première ou sur la seconde ligne de données tandis que des données précédentes sont respectivement lues depuis la seconde ou première ligne de données par l'intermédiaire du moyen de commutation et du moyen de sortie.

2. Dispositif de mémoire selon la revendication 1, caractérisé en ce que :
une opération de commutation dudit moyen de commutation (38, 39) est réalisée de telle sorte qu'un premier intervalle (ST1 - ST5, ST21 - ST23) défini depuis l'instant auquel l'une desdites premières sources de données (20, 22) est accédée par ledit moyen de connexion (24, 26, 28, 30, 32, 34, 36) jusqu'à l'instant auquel les données (DBA = SO) de l'une desdites premières sources de données (20, 22) sont émises en sortie depuis ledit moyen de sortie (40) chevauche partiellement un second intervalle (ST31 - ST35, ST11 - ST13) défini depuis l'instant auquel l'une desdites secondes sources de données (21, 23) est accédée par ledit second moyen de connexion (25, 27, 29, 31, 33, 35, 37) jusqu'à l'instant auquel des données (DBB = SO) de l'une desdites secondes sources de données (21, 23) sont émises en sortie depuis ledit moyen de sortie (40).

3. Dispositif de mémoire selon la revendication 2, caractérisé en ce que :
l'opération de commutation dudit moyen de commutation est réalisée tous les N cycles opératoires dudit dispositif de mémoire, N étant un entier égal à 1 ou plus, et un bit de données est extrait pendant un cycle opératoire.

4. Dispositif de mémoire selon la revendication 3, caractérisé en ce que :
ledit moyen de commutation (38, 39) inclut un premier moyen de tampon (38) pour connecter de façon sélective ladite première ligne de données (DBA) audit moyen de sortie (40) et un second moyen de tampon (39) pour connecter de façon sélective ladite seconde ligne de données (DBB) audit moyen de sortie (40) et lesdits premier et second moyens de tampon (38, 39) sont en alternance ouverts/fermés tous les N cycles opératoires pour réaliser l'opération de commutation.

5. Dispositif de mémoire selon l'une quelconque des revendications 1 à 3, caractérisé en ce que :
ledit moyen de commutation (38, 39) inclut un premier moyen de registre (380, 38a - 38c) pour stocker temporairement des données en provenance de l'une ou l'autre desdites premières sources de données (20, 22) et pour appliquer de façon sélective les données stockées audit moyen de sortie (40), et un second moyen de registre (390, 39a - 39c) pour stocker temporairement des données en provenance de l'une ou l'autre desdites secondes sources de données (21, 23) et pour appliquer de façon sélective les données stockées audit moyen de sortie (40) et en ce que lesdits premier et second moyens de registre (380, 390, 38a - 38c, 39a - 39c) sont actionnés en alternance pour réaliser une opération d'application sélective.

6. Dispositif de mémoire selon la revendication 5, comprenant en outre :
un moyen de commande (41 - 46) pour commander l'opération de commutation desdits premier et second moyens de registre (380, 390, 38a - 38c, 39a - 39c) de telle sorte que des données en provenance de l'une ou l'autre desdites secondes sources de données (21, 23) soient temporairement stockées dans ledit second moyen de registre (390, 39a - 39c) pendant un intervalle au cours duquel les données temporairement stockées dans ledit premier moyen de registre (380, 38a - 38c) sont appliquées audit moyen de sortie (40), et de telle sorte que des données en provenance de l'une ou l'autre desdites premières sources de données (20, 22) soient temporairement stockées dans ledit premier moyen de registre (380, 38a - 38c) pendant un intervalle au cours duquel les données temporairement stockées dans ledit second moyen de registre (390, 39a - 39c) sont appliquées audit moyen de sortie (40).

7. Dispositif de mémoire du type à accès série comprenant :
une première source de données (20, 22) et une seconde source de données (21, 23) ;
une première ligne de données (DBA) et une seconde ligne de données (DBB) ;
des premier et second moyens de connexion (24, 26, 28, 30, 32, 34, 36 et 25, 27, 29, 31, 33, 35, 37) pour connecter respectivement de façon sélective ladite première source de données (20, 22) à ladite première ligne de données (DBA) et ladite seconde source de données (21, 23) à ladite seconde ligne de données (DBB) ;
un moyen d'entrée (400) pour appliquer des données d'écriture (S1) à l'une ou l'autre desdites premières et secondes sources de données (20 à 23) au travers de l'une correspondante desdites première et seconde lignes de données (DBA, DBB) ; et
un premier moyen de commutation (386, 396) pour appliquer de façon sélective les données d'écriture (S1) en provenance dudit moyen d'entrée (400) à l'une ou l'autre desdites première et seconde lignes de données (DBA, DBB) ;
dans lequel :
ledit premier moyen de connexion (24, 26, 28, 30, 32, 34 et 36) inclut :
un premier générateur d'adresses (36) pour générer des premières données d'adresse (AA) mises à jour en synchronisation avec une opération de commutation dudit moyen de commutation (38, 39) ;
un premier moyen de porte (24, 26, 28, 30, 32, 34) pour connecter ladite première source de données (20, 22) à ladite première ligne de données (DBA) en relation avec un contenu des premières données d'adresse (AA) ;
ledit second moyen de connexion (25, 27, 29, 31, 33, 35, 37) inclut :
un second générateur d'adresses (37) pour générer des secondes données d'adresse (AB) mises à jour en synchronisation avec une opération de commutation dudit moyen de commutation (38, 39) ;
un second moyen de porte (25, 27, 29, 31, 33, 35) pour connecter ladite seconde source de données (21, 23) à ladite seconde ligne de données (DBB) en relation avec un contenu des secondes données d'adresse (AB) ; et
un cadencement de mise à jour des premières données d'adresse (AA) est décalé par rapport à un cadencement de mise à jour des secondes données d'adresse (AB) d'où il résulte que des données courantes sont placées sur la première ou sur la seconde ligne de données tandis que des données précédentes sont entrées par l'intermédiaire de la seconde ou de la première ligne de données respectivement au travers du second moyen de commutation et du moyen d'entrée.

8. Dispositif de mémoire selon la revendication 7, comprenant en outre :
un moyen de sortie (40) pour émettre en sortie des données lues (SO) émises en sortie depuis l'une ou l'autre desdites premières et secondes sources de données (20 - 23) au travers de l'une correspondante desdites première et seconde lignes de données (DBA, DBB) ; et
un moyen de commutation de lecture (38, 39) pour connecter de façon sélective l'une ou l'autre desdites première et seconde lignes de données (DBA, DBB) audit moyen de sortie (40).
